# EUROPÄISCHE PATENTANMELDUNG

(11) **EP 0 954 085 A1**
(43) Veröffentlichungstag der Anmeldung: **03.11.1999**
(21) Anmeldenummer: 98810370.1
(22) Anmeldetag: 27.04.1998
(51) Int. Cl.: H02K 29/08, H01L 43/06, G01R 33/06

(54) **Senkrechter Hallsensor und bürstenloser Elektromotor mit einem senkrechten Hallsensor**

(71) Anmelder: Roulements Miniatures S.A., 2500 Biel (CH)
(72) Erfinder: Drapp, Axel, 2503 Biel (CH); Biétry, André, 2944 Bonfol (CH); Burger, Frédéric, 1206 Genève (CH); Popovic, Radivoje, 1025 St-Sulpice (CH)
(74) Vertreter: Liebetanz, Michael, Dipl.-Phys.

(57) **Zusammenfassung**

Ein senkrechter Hallsensor (80) besteht aus einem Halbleiterkristall (1) mit drei oder mehr Armabschnitten (9, 29, 49), die in einem gleichmässigen Winkelabstand zueinander angeordnet sind. Auf der Oberfläche (61) des Sensors sind eine mittlere Stromelektrode (2) und äussere Stromelektroden (3, 23, 43) angeordnet, zwischen denen jeweils Hallspannungskontakte (4, 24, 44) angeordnet sind. Dabei weist der Halbleiterkristall (1) eine ausreichende Dicke auf, so dass zwischen den Stromelektroden (2 und 3, 23, 43) in jedem Armabschnitt (9, 29, 49) des Halbleiterkristalls (1) ein Stromfluss (13; 33) ermöglicht wird, der für ein parallel zu der Oberfläche (61) ausgerichtetes Magnetfeld mehrere Empfindlichkeiten des Hallsensors entsprechend der Armanzahl und mit einer entsprechend vorgegebenen Winkelabhängigkeit erzeugt. Die mit einem solchen mehrarmigen senkrechten Hallsensor erzeugbaren Hallspannungen können verstärkt und direkt als Leistungssignal für einen Elektromotor Verwendung finden.

## Beschreibung

Die Erfindung betrifft einen senkrechten Hallsensor aus einem Halbleiterkristall mit auf der Oberfläche desselben angeordneten Paar von Stromelektroden und mit einem zwischen den Stromelektroden angeordneten Hallspannungskontakt, wobei der Halbleiterkristall eine ausreichende Dicke aufweist, so dass zwischen den Stromelektroden in dem Halbleiterkristall ein Stromfluss ermöglicht wird, der eine Empfindlichkeit des Hallsensors für ein parallel zu der Oberfläche ausgerichtetes Magnetfeld erzeugt.

Die Erfindung betrifft weiterhin einen bürstenlosen Elektromotor mit mindestens einem Hallsensor und mit einem Permanentmagneten, wobei der Permanentmagnet drehfest mit der Motorwelle verbunden und der Hallsensor diesem Permanentmagneten gegenüber angeordnet ist, wobei der Elektromotor mindestens drei Spulen aufweist.

Ein senkrechter Hallsensor ist aus der US 4,987,467 bekannt. Senkrechte Hallsensoren sind integrierte Hallsensoren und weisen den Vorteil auf, auf ein Magnetfeld parallel zur Chip-Oberfläche empfindlich zu sein. Solche Hallsensoren werden insbesondere für genaue Messungen von Magnetfeldern eingesetzt.

Bekannte übliche Hallsensoren werden auch für die Steuerung von Elektromotoren eingesetzt. Ein entsprechender bürstenloser Elektromotor mit der dazugehörigen Steuerung ist aus dem Artikel "Effects of Software Speed-Control Algorithm on Low-Cost Six-Step Brushless DC Drives" von S. Ellerthorpe in Power Conversion-&-Intelligent Motion, Band 22, Nr. 1, Seiten 58 bis 65 (Januar 1996) bekannt.

In dem genannten Motor werden drei Hallsensoren, die jeweils 180° einer Kreisscheibe parallel zum Permanentmagneten abdecken, mit einem Versatz von 120° zueinander angeordnet, so dass die von diesen Hallsensoren erzeugten Spannungen ein Drei-Bit-Rückkopplungssignal ergeben, welches die Rotorposition in Bezug auf sechs 60°-Bereiche feststellt. Die diesbezügliche Information wird in IP-, PI- und PPI-Steuerungen zur Erreichung einer konstanten Drehzahl bei dem Elektromotor eingesetzt.

Dieser Motor weist den Nachteil auf, dass die entsprechenden die Algorithmen der Steuerung ausfuhrenden Systeme einen Raumbedarf haben, der die Möglichkeiten zur Miniaturisierung der Motoren stark einschränkt. Die Anordnung der Hallsensoren ist in Bezug auf die fluchtende Planarität sowie im Hinblick auf die genaue Ausrichtung der Winkel zueinander schwierig.

Ausgehend von diesem Stand der Technik liegt der Erfindung die Aufgabe zugrunde, einen senkrechten Hallsensor der eingangs genannten Art so auszubilden, dass mit ihm bessere Winkelauflösungen erreichbar sind, insbesondere dass bei Beaufschlagung mit einem sich drehenden Magnetfeld drei um jeweils 120° verschobene Hall-Spannungen erzeugbar sind.

Weiterhin ist ausgehend von dem genannten Stand der Technik Aufgabe der Erfindung, einen mit einem senkrechten Hallsensor ausgestatteten Elektromotor so auszubilden, dass er als Mikromotor mit möglichst geringem Raumbedarf und einfacher Ansteuerung ausgestaltet werden kann.

Die erste genannte Aufgabe wird erfindungsgemäss für einen senkrechten Hallsensor der eingangs genannten Art dadurch gelöst, dass der Hallsensor über drei oder mehr Armabschnitte verfügt, die in einem gleichmässigen Winkelabstand zueinander angeordnet sind und die in einem zentralen Abschnitt zusammenlaufen, dass jeder Arm über eine äussere Stromelektrode verfügt, der gegenüber im zentralen Abschnitt eine mittlere innere Stromelektrode angeordnet ist, die jeweils das besagte Paar von Stromelektroden bilden, und dass zwischen den jeweiligen äusseren Stromelektroden und der mittleren inneren Stromelektrode ein Hallspannungskontakt angeordnet ist, so dass zwischen den Stromelektroden in jedem Armabschnitt des Halbleiterkristalls ein Stromfluss ermöglicht wird, der für ein parallel zu der Oberfläche ausgerichtetes Magnetfeld mehrere Ausgangssignale des Hallsensors entsprechend der Armanzahl und mit einer entsprechend vorgegebenen Winkelabhängigkeit erzeugt.

Dadurch, dass verschiedene Arme jeweils einen vollständigen Hallsensor bilden, kann in sehr genauer Weise eine Empfindlichkeit des Hallsensors für verschiedene Winkel des Magnetfeldes in der Ebene der Kristalloberfläche erreicht werden. Durch die in tegrierte Ausführung ist neben der hervorragenden Genauigkeit der Winkel der Sensoren zueinander durch die gemeinsame Kristalloberfläche auch die Empfindlichkeit für dieselben Anteile des Magnetfeldes gegeben.

Die weitere Aufgabe wird erfindungsgemäss für einen Elektromotor der eingangs genannten Art dadurch gelöst, dass der Hallsensor ein erfindungsgemässer senkrechter Hallsensor mit mindestens drei Armen ist, dass die Anzahl der Arme der Anzahl der Spulen entspricht, so dass mit dem senkrechten Hallsensor bei drehender Motorwelle mindestens drei mit gleichem Phasenabstand zueinander phasenverschobene Hallspannungen erzeugbar sind, die verstärkt den Spulen als Leistungssignal zuführbar sind.

Durch die Verwendung des erfindungsgemässen senkrechten Hallsensors bei einem bürstenlosen Elektromotor kann eine sehr einfache Beschaltung desselben erreicht werden, was für die Miniaturisierung der gesamten Einheit sehr vorteilhaft ist.

Weitere vorteilhafte Ausführungsformen sind in den jeweiligen Unteransprüchen gekennzeichnet.

Die Erfindung wird nun unter Bezugnahme auf die beigefügten Zeichnungen im Detail an verschiedenen Ausführungsbeispielen der Erfindung beschrieben. Es zeigen:
- Fig. 1: einen bekannten linearen senkrechten Hallsensor mit einer Weiterbildung hinsichtlich des Signalabgriffs,
- Fig. 2: eine Ansicht eines dreiarmigen Hallsensors gemäss einem Ausführungsbeispiel der Erfindung,
- Fig. 3: eine Querschnittsansicht durch einen miniaturisierten Elektromotor mit einem erfindungsgemässen mehrarmigen senkrechten Hallsensor nach Fig. 2,
- Fig. 4: eine schematische Ansicht eines Schaltbildes zur Ansteuerung des Motors nach Fig. 3 mit dem dreiarmigen senkrechten Hallsensor nach Fig. 2, und
- Fig. 5: eine schematische Ansicht eines Schaltbildes zur Ansteuerung eines fünf Spulen umfassenden Elektromotors mit einem fünfarmigen senkrechten Hallsensor gemäss einem weiteren Ausführungsbeispiel der Erfindung.

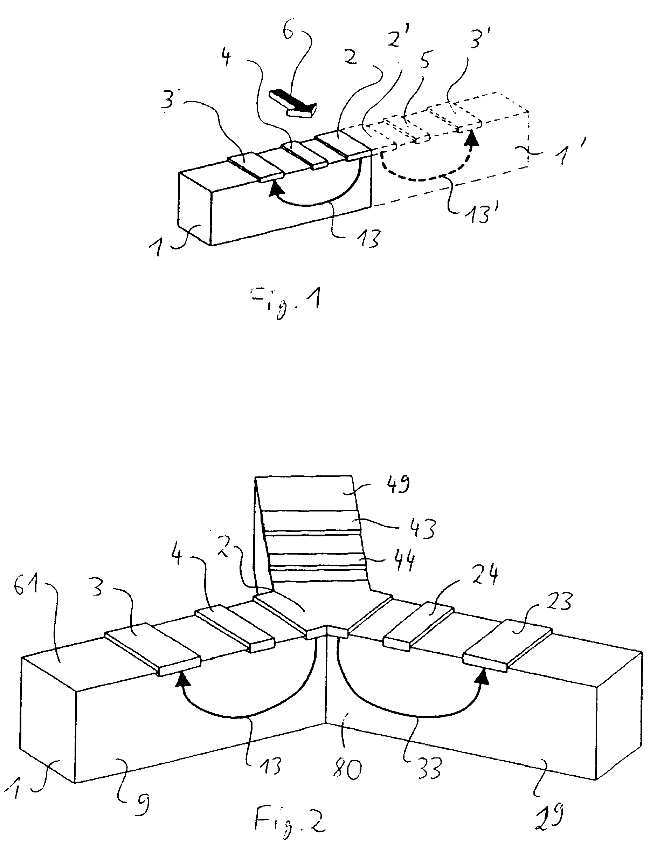

Die Fig. 1 zeigt einen bekannten senkrechten Hallsensor, dessen Grundprinzipien in der US 4,987,467 beschrieben sind. Diese Druckschrift wird hiermit als Referenz zum Aufbau eines solchen Sensors in die vorliegende Offenbarung aufgenommen.

Ein Halbleiterkristall 1 ist die Basis für das Hall-Element oder den Hallsensor, wobei dieser Kristall 1 ein Quader ist und wobei gegenüberliegende Seiten somit parallel verlaufen. Mit den Bezugszeichen 2 und 3 sind die auf der Oberfläche des Kristalls 1 aufgebrachten Stromelektroden bezeichnet. Zwischen diesen ist ein erster Sensorkontakt 4 angeordnet, wobei alle drei Kontakte und Elektroden streifenförmig sind und parallel zueinander verlaufen. Ein in der US 4,987,467 beschriebenes sogenanntes senkrechtes Hall-Element verfügt dann zudem über den strichlinierten Anteil des Kristalls 1' mit der ersten inneren Stromelektrode 2', der zweiten äusseren Stromelektrode 3' sowie einem zweiten Sensorkontakt 5. Innerhalb des Kristallmaterials 1 wird eine leitfähigere Verbindung 13 zwischen den Stromelektroden 2 und 3 sowie eine leitfähigere Verbindung 13' zwischen den Stromelektroden 2' und 3' ausgebildet. Damit ergibt sich bei Beaufschlagung dieses sogenannten senkrechten Hallsensors mit einem entsprechend dem Pfeil 6 ausgerichteten Magnetfeld eine Hall-Spannung zwischen den beiden Sensorelektroden 4 und 5, wobei auch hier die verschiedenen Verbindungsebenen zwischen den Kontaktpunkten 4 und 5 bzw. 2, 2' und 3, 3' sowie dem Magnetfeld 6 jeweils senkrecht verlaufen. Die inneren Stromelektroden 2 und 2' sind einstückig und bilden einen Streifen.

Es ist nun möglich, auf den strichlinierten Teil des senkrechten Hallsensors zu verzichten und somit nur mit einer Hälfte zu arbeiten, sofern auf der Rückseite der Sensoren ein zweiter Abgriff für die Hallspannung vorgesehen ist.

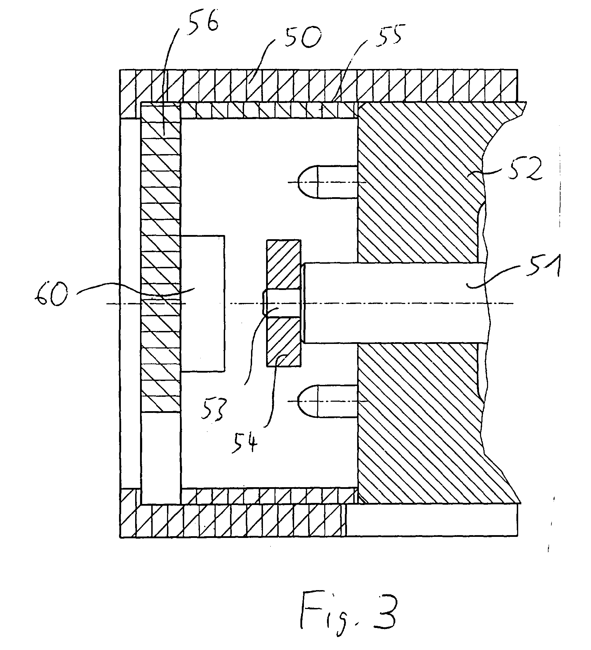

Die Fig. 2 zeigt einen dreiarmigen senkrechten Hallsensor gemäss einem Ausführungsbeispiel der Erfindung in einer Ansicht, wobei gleiche Merkmale in allen Fig. jeweils mit gleichen Bezugszeichen bezeichnet worden sind. Die einzige zentrale Stromelektrode 2 ist funktional für alle drei Arme 9, 29 und 49 vorgesehen. Dieser Stromelektrode 2 gegenüber sind die äusseren Stromelektroden 3, 23 und 43 angeordnet. Zwischen der zentralen Elektrode 2 und den äusseren Elektroden 3, 23 bzw. 43 sind jeweils die Sensorkontakte oder Hallspannungselektroden 4, 24 und 44 angeordnet. Neben dem ersten Schichtenverlauf der leitfähigeren Schicht 13 im ersten Arm 9 ist auch die entsprechende Schichtenführung 33 im zweiten Arm 29 dargestellt.

Es ist entsprechend der US 4,987,467 möglich, diese leitfähige Schicht in einer Vielzahl von Ausgestaltungen vorzunehmen, dies kann insbesondere auch durch das Vorsehen einer gut leitenden, sogenannten beerdigten Schicht ("buried layer") desselben Leitfähigkeitstyps wie dem des den Kristall 1 aufbauenden Halbleiters bestehen.

Die Fig. 3 zeigt nun eine Ansicht eines Miniaturmotors, der innerhalb eines Gehäuses 50 angeordnet ist. Mit dem Bezugszeichen 51 ist die Welle bezeichnet, die in einer Hülse 52 gelagert ist. Auf der Welle 51 ist auf einem Fortsatz 53 ein Permanentmagnet 54 drehfest angeordnet. Der Permanentmagnet 54 ist zylindrisch und weist eine Bohrung auf. Ihm gegenüber ist in möglichst geringem Abstand der senkrechte mehrarmige Hallsensor 60 angeordnet, der insbesondere entsprechend der Fig. 2 ausgestaltet sein kann, wobei die in der Fig. 2 mit dem Bezugszeichen 61 bezeichnete Kristalloberfläche auf den Permanentmagneten 54 ausgerichtet ist.

Vorteilhafterweise wird auf das Gehäuse 52 ein rohrförmiger Abstandhalter 55 aufgesetzt, auf den eine den Sensor 60 tragende Leiterplatte 56 aufgesetzt und mit dem Gehäuse 50 gekontert wird. Dadurch ist in einfacher Weise eine genaue parallele Ausrichtung von Magnet 54 und Sensor 60 erreichbar.

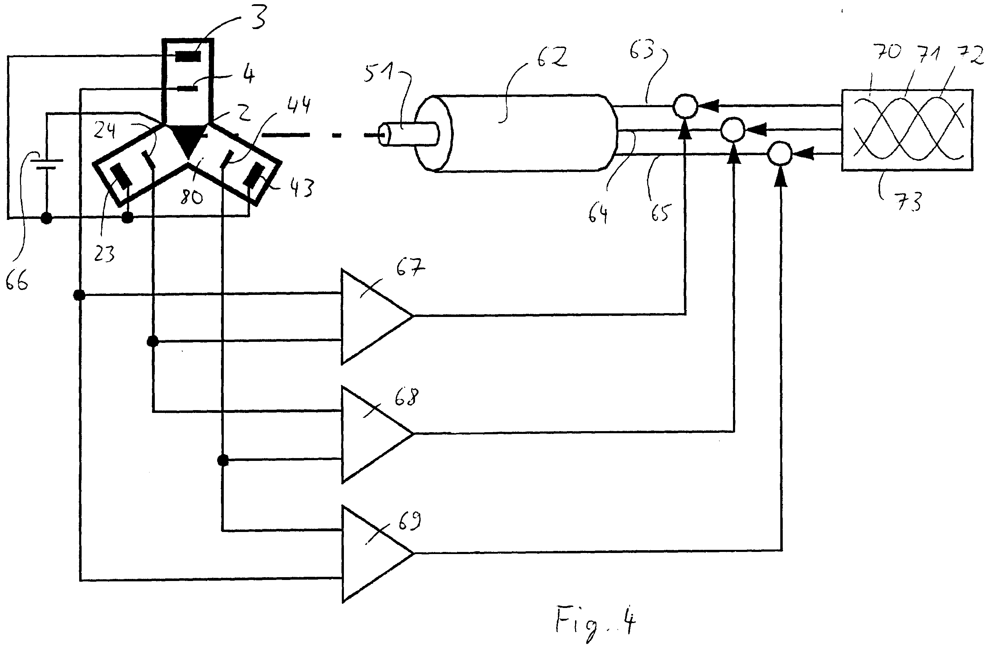

Die Beschaltung des Motors nach Fig. 3 ist nun in der Fig. 4 dargestellt, die ein prinzipielles Schaltbild für einen Elektromotor gemäss der Erfindung zeigt. Der Elektromotor 62 verfügt über drei Spulen, die Zuleitungen 63, 64 und 65 aufweisen. Mit dem Bezugszeichen 51 ist wiederum die Welle, die den Permanentmagnet 60 trägt, bezeichnet und ihr gegenüber ist in einer schematischen Darstellung stilisiert in einer Draufsicht der dreiarmige senkrechte Hallsensor angeordnet. Die äusseren Stromelektroden 3, 23 und 43 sind zusammengeschaltet und über eine Stromquelle 66 mit der inneren Stromelektrode 2 verbunden. Die drei Spannungselektroden 4, 24 und 44 sind jeweils mit ersten Eingängen von Verstärkerstufen 67, 68 und 69 verbunden. Die weiteren Eingänge der Verstärker 67, 68 und 69 sind jeweils mit gegen den Uhrzeigersinn folgenden Spannungselektroden verbunden. Die Verstärkerstufen 67, 68 und 69 sind somit mit den um jeweils 120° phasenverschobenen Hall-Spannungen der drei unabhängigen Hallsensoren im senkrechten Hallsensor beaufschlagt. Diese drei Signale 70, 71 und 72 sind schematisch in dem Element 73 dargestellt. Vorzugsweise werden diese Signale in den Verstärkern 67, 68 und 69 entsprechend verstärkt, um direkt auf die Zuleitungen 63, 64 und 65 gegeben werden zu können, so dass der bürstenlose und vorzugsweise miniaturisierte Elektromotor 62 ohne eine weitere elektrische Versorgungsschaltung angetrieben wird. Die mit einem erfindungsgemässen mehrarmigen senkrechten Hallsensor erzeugbaren Hallspannungen können also verstärkt als Leistungssignal für einen Elektromotor Verwendung finden.

Das Element 73 kann eine zusätzliche externe Spannungsquelle sein, die drei phasenverschobenen Signale 70, 71 und 72 erzeugt und zum Anlaufen und/oder zum Mischen mit den Signalen der Verstärkerstufen 67, 68 und 69 für den Elektromotor 62 bereitstellt.

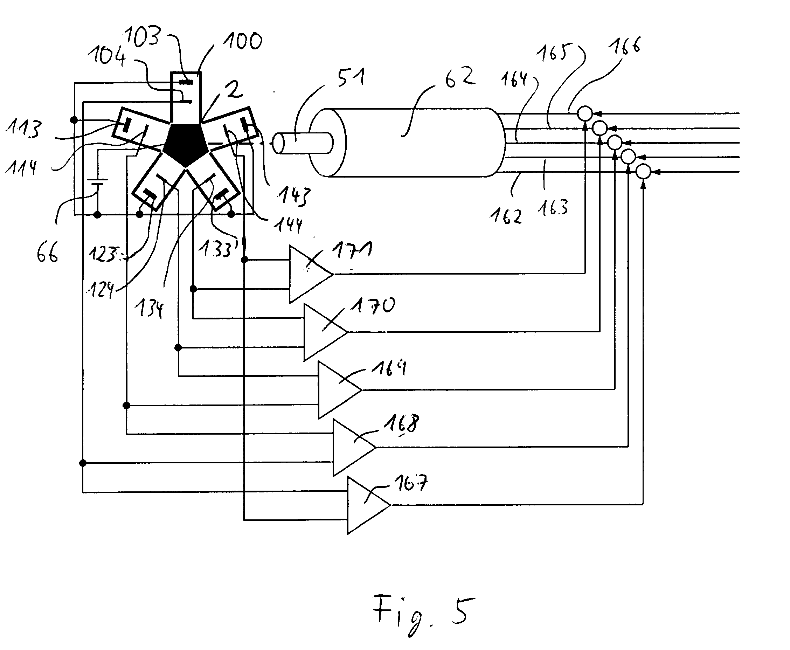

Neben dem dreiarmigen Hallsensor 80 nach Fig. 4 ist ebenfalls jede andere mehrarmige Ausgestaltung des Hallsensors möglich. In der Fig. 5 ist ein Schaltbild entsprechend Fig. 4 für einen fünfarmigen Hallsensor 100 dargestellt. Zu der zentralen Stromelektrode 2 treten nun fünf äussere Stromelektroden 103, 113, 123, 133 und 143 hinzu. Alle äusseren Stromelektroden sind wiederum mit der inneren Stromelektrode 2 über eine Stromquelle 66 verbunden. Zwischen den jeweiligen Stromelektrodenpaaren 2 und 103, 113, 123, 133 bzw. 143 sind Hallspannungselektroden 104, 114, 124, 134 und 144 angeordnet. In analoger Weise zur Fig. 4 ist dann eine den Armen entsprechende Anzahl von hier fünf Verstärkerstufen 167, 168, 169, 170 und 171 vorgesehen. Auch hier gehen von den fünf Verstärkern entsprechende Zuleitungen zu den fünf Spulenzuführungen 162, 163, 164, 165 und 166 für den Elektromotor 62.

In den oben beschriebenen Ausführungsbeispielen für den senkrechten Hallsensor ist jeweils ein konstanter Strom über die Elektroden 2 und 3, 23, ... eingeleitet und die Hall-Spannung abgegriffen worden. Diese Vorgehensweise führt zu jeweils phasenverschobenen Ausgangssignalen, die um 0 Volt oszillieren und damit im wesentlichen keinen Gleichspannungsanteil aufweisen. Dagegen wird bei einem Betrieb der beschriebenen Hallsensoren bei konstanter Spannung und somit variablem Strom eine Oszillation der Ausgangsspannung um einen von null verschiedenen Wert von z.B. 3 Volt, d.h. mit einem Gleichspannungsanteil, erreicht.

Neben der dargestellten Möglichkeit der Differenzbildung in den Verstärkerstufen 67 bzw. 167 und folgenden, kann jedes Ausgangssignal der Hallspannungskontakte auch individuell verstärkt und dem Motor 62 zugeführt werden. Dieser in den Zeichnungen nicht dargestellte Fall führt zu einer Verschiebung der Hallspannungen bei verschiedenen Magnetfeldstärken, d.h. dass die Ausgangsspannungen bei den 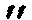 Nulldurchgängen" der dreiarmigen Sensoren bei 0 und 180 bzw. 60 und 240 bzw. 120 und 300 Grad bei verschiedenen Magnetfeldstärken ungleich sind.

Der erfindungsgemässe Hallsensor weist neben dem beschriebenen Einsatz für den Antrieb von Mikromotoren weitere Anwendungsmöglichkeiten in all denjenigen Bereichen auf, in denen in verschiedenen Orientierungen arbeitende Hallsensoren auf engem Raum benötigt werden. Neben den dargestellten drei- und fünfarmigen senkrechten Hallsensoren ist auch jede andere Zahl von Sensorarmen grösser als drei möglich.

Der Sensor an sich weist den Vorteil auf, dass es sich um einen integrierten Sensor handelt, der bei seiner Herstellung keinerlei Probleme hinsichtlich der parallelen und hier fluchtenden Ausrichtung der Ebenen der Kontaktflächen, hier in der Oberfläche 61, aufweist. Auch die Kontaktflächen selber sind in ihrer Ausrichtung und Grösse sehr genau vorbestimmbar. Durch die Integration ist beim dreiarmigen Sensor nach Fig. 2 der Winkel von 120° bzw. beim fünfarmigen Sensor, der in Fig. 5 dargestellt ist, der Winkel von 72° zwischen benachbarten Armen mit höchster Genauigkeit erzeugbar.

Bei einer geradzahligen Armzahl des Hallsensors, z.B. sechs, können neben der im Zusammenhang mit den Fig. beschriebenen Weise von dann hier sechs im Phasenabstand von 60 Grad liegenden Hallspannungsempfindlichkeiten jeweils gegenüberliegende Hallsensorarme zusammengeschaltet werden, um einen vollständigen senkrechten Hallsensor nach Fig. 1 zu bilden. In dem in diesem Abschnitt gewählten Beispiel von sechs Armen ergeben sich dann drei Hallspannungsempfindlichkeiten im Phasenabstand von 120 Grad zueinander wie bei dem dreiarmigen Hallsensor nach Fig 2. Der Schaltungsaufwand ist jedoch erheblich höher. Der Vorteil der Lösung nach den Fig. 2 und 3 liegt insbesondere auch daran, dass eine erheblich geringere Anzahl von Kontakten notwendig und eine einfachere Beschaltung des Sensors möglich ist.

## Patentansprüche

1. Senkrechter Hallsensor (60; 80; 100) aus einem Halbleiterkristall (1) mit auf der Oberfläche (61) desselben angeordneten Paar von Stromelektroden (2, 3) und mit einem zwischen den Stromelektroden (2, 3) angeordneten Hallspannungskontakt (4), wobei der Halbleiterkristall (1) eine ausreichende Dicke aufweist, so dass zwischen den Stromelektroden (2, 3) in dem Halbleiterkristall (1) ein Stromfluss (13) ermöglicht wird, der eine Empfindlichkeit des Hallsensors für ein parallel zu der Oberfläche (61) ausgerichtetes Magnetfeld (6) erzeugt, **dadurch gekennzeichnet**, dass der Hallsensor über drei oder mehr Armabschnitte (9, 29, 49; 100) verfügt, die in einem gleichmässigen Winkelabstand zueinander angeordnet sind und die in einem zentralen Abschnitt zusammenlaufen, dass Jeder Arm über eine äussere Stromelektrode (3, 23, 43; 103, 113, 123, 133, 143) verfügt, der gegenüber im zentralen Abschnitt eine mittlere innere Stromelektrode (2) angeordnet ist, die jeweils das besagte Paar von Stromelektroden bilden, und dass zwischen den jeweiligen äusseren Stromelektroden (3, 23, 43; 103, 113, 123, 133, 143) und der mittleren inneren Stromelektrode (2) ein Hallspannungskontakt (4, 24, 44; 104, 114, 124, 134, 144) angeordnet ist, so dass zwischen den Stromelektroden (2 und 3, 23, 43; 103, 113, 123, 133, 143) in jedem Armabschnitt (9, 29, 49; 100) des Halbleiterkristalls (1) ein Stromfluss (13, 33, ... ) ermöglicht wird, der für ein parallel zu der Oberfläche (61) ausgerichtetes Magnetfeld (6) mehrere Ausgangssignale des Hallsensors entsprechend der Armanzahl und mit einer entsprechend vorgegebenen Winkelabhängigkeit erzeugt.

2. Senkrechter Hallsensor (60; 80; 100) nach Anspruch 1, dadurch gekennzeichnet, dass drei Armabschnitte (9, 29, 49) vorgesehen sind, die in einem Winkel von 120 Grad zueinander angeordnet sind.

3. Senkrechter Hallsensor (60; 80; 100) nach Anspruch 1 oder Anspruch 2, dadurch gekennzeichnet, dass zur Erzeugung des Stromflusses (13, 33, ...) eine beerdigte Schicht in jedem Arm (9, 29, 49; ...) des Halbleiterkristall (1) vorgesehen ist.

4. Senkrechter Hallsensor (60; 80; 100) nach einem der vorstehenden Ansprüche, dadurch gekennzeichnet, dass die äusseren Stromelektroden (3, 23, 43; 103, ...) elektrisch leitende Streifen sind und dass die Hallspannungskontakte (4, 24, 44; 104, ...) parallel zu den äusseren Stromelektroden (3, 23, 43; 103, ...) angeordnete elektrisch leitende Streifen sind.

5. Bürstenloser Elektromotor (62) mit mindestens einem Hallsensor (60; 80; 100) und mit einem Permanentmagneten (54), wobei der Permanentmagnet (54) drehfest mit der Motorwelle (51) verbunden und der Hallsensor (60; 80; 100) diesem Permanentmagneten (54) gegenüber angeordnet ist, wobei der Elektromotor (62) mindestens drei Spulen (63, 64, 65; 163, ...) aufweist, **dadurch gekennzeichnet**, dass der Hallsensor ein senkrechter Hallsensor (60; 80; 100) nach einem der Ansprüche 1 bis 4 mit mindestens drei Armen (9, 29, 49) ist, dass die Anzahl der Arme (9, 29, 49; ...) der Anzahl der Spulen (63, 64, 65; 163, ...) entspricht, so dass mit dem senkrechten Hallsensor (60; 80; 100) bei drehender Motorwelle (51) mindestens drei mit gleichem Phasenabstand zueinander phasenverschobene Hallspannungen erzeugbar sind, die verstärkt (67, 68, 69; 167, ... ) den Spulen (63, 64, 65; 163, ...) als Leistungssignal zuführbar sind.

6. Elektromotor (62) nach Anspruch 5, dadurch gekennzeichnet, dass aufeinanderfolgende Hallspannungskontakte (4, 24, 44; 104, ... ) jeweils mit den Eingängen von Differenzverstärkern (67, 68, 69; 167, ...) verbunden sind, so dass im wesentlichen gleichspannungsfreie verstärkte Hallspannungen (70, 71, 72) den Spulen des Elektromotors (62) zuführbar sind.

7. Elektromotor (62) nach Anspruch 5, dadurch gekennzeichnet, dass die Hallspannungskontakte (4, 24, 44; 104, ... ) jeweils individuell mit Verstärkern verbunden sind, deren Ausgänge die Spulen des Elektromotors (62) beaufschlagen.

8. Elektromotor (62) nach einem der Ansprüche 5 bis 7, dadurch gekennzeichnet, dass der Hallsensor (60; 80; 100) bei konstantem Strom betrieben wird.

9. Elektromotor (62) nach einem der Ansprüche 5 bis 8, dadurch gekennzeichnet, dass der Hallsensor (60; 80) drei Arme (9, 29, 49) und der Elektromotor (62) drei Spulen (63, 64, 65) aufweist.
